# EUROPEAN PATENT APPLICATION

(11) **EP 4 733 434 A1**
(43) Date of publication of application: **29.04.2026**
(21) Application number: 24826043.2
(22) Date of filing: 24.06.2024
(51) Int. Cl.: C23C 16/42, C23C 16/505

(54) **SILICON OXIDE VAPOR-DEPOSITED FILM AND MOLDED ARTICLE INCLUDING THE SAME**

(30) Priority: 23.06.2023 JP 2023103048; 25.01.2024 JP 2024009396
(71) Applicant: THE NISSHIN OILLIO GROUP, LTD., Tokyo 104-8285 (JP)
(72) Inventor: METOKI, Junya, Yokohama-shi, Kanagawa 235-8558 (JP); MURANO, Yoshihiro, Yokohama-shi, Kanagawa 235-8558 (JP); KURIMOTO, Takayuki, Yokohama-shi, Kanagawa 235-8558 (JP); HAYAKAWA, Tetsuhiko, Yokohama-shi, Kanagawa 235-8558 (JP); OTSUBO, Yuki, Yokohama-shi, Kanagawa 235-8558 (JP)
(74) Representative: Hasegawa, Kan
(86) International application number: PCT/JP2024/022824
(87) International publication number: WO 2024/262642

(57) **Abstract**

An object of the present invention is to provide a silicon oxide vapor-deposited film having excellent roll-off property and/or oil-repellency for oils and/or fats or an oil and/or fat-containing composition, and a molded article coated with a silicon oxide vapor-deposited film having excellent roll-off property and/or oil-repellency for oils and/or fats or an oil and/or fat-containing composition. Specifically, the present invention provides a silicon oxide vapor-deposited film, wherein a surface of the silicon oxide vapor-deposited film has a ratio of ion intensity AO to ion intensity B (ion intensity AO/ion intensity B) of 3 or above in an ion intensity spectrum obtained by time-of-flight secondary ion mass spectrometry.

## Description

### Technical Field

The present invention relates to a silicon oxide vapor-deposited film and a molded article coated with a silicon oxide vapor-deposited film. The present invention particularly relates to a silicon oxide vapor-deposited film having high roll-off property and/or oil repellency for oils and/or fats or the like, and a molded article including the same.

### Background Art

Conventionally, forming a film on a surface has been performed to improve the properties of various substrates. For example, in packaging materials, a vapor-deposited film is formed by a plasma CVD method on the surface of a plastic molded article to improve gas barrier properties.

For example, a method for producing a plastic container is known, wherein the concentration of an organosilicon compound is changed when forming a barrier layer (vapor-deposited film) containing a silicon oxide and at least one compound composed of at least one element selected from carbon, hydrogen, silicon, and oxygen, on at least one side of a plastic container by a plasma CVD method using at least an organosilicon compound and oxygen or a gas having oxidizing power. Note that the gas flow rate ratio between the organosilicon compound (hexamethyldisiloxane) and oxygen was 1:2, 1:20, and 1:100 (see Patent Literature 1).

Also, it has been shown that a silicon oxide film produced with a flow rate ratio of an organosilicon compound gas to a gas containing oxygen atoms in a range of 1:3 to 50, and having a component ratio of 170 to 200 O atoms and 30 or less C atoms per 100 Si atoms, has gas barrier properties (see Patent Literature 2).

On the other hand, for articles such as containers and cooking utensils, if cleanability after use and dischargeability of contents are good, workability improves and the environmental load is also reduced. For this reason, water or oil repellency is also required as a property of substrates such as containers and cooking utensils. For water repellency, for example, a bottle with good drainage properties has been proposed, which is obtained by depositing an organosilicon compound film containing nitrogen, silicon, carbon, and hydrogen, and forming a silicon oxide compound film mainly composed of a silicon oxide compound on its surface by a CVD method (gas flow rate ratio of hexamethyldisiloxane to oxygen of 1:4) (see Patent Literature 3).
However, a silicon oxide compound film with good oil repellency has not been sufficiently studied.

### Citation List

### Patent Literatures

Patent Literature 1: Japanese Unexamined Patent Application Publication No. 2000-255579
Patent Literature 2: Japanese Unexamined Patent Application Publication No. 2003-53873
Patent Literature 3: Japanese Unexamined Patent Application Publication No. 2009-46162

### Summary of Invention

One object of the present invention is to provide a silicon oxide vapor-deposited film with high roll-off property and/or oil repellency for oils and/or fats or an oil and/or fat-containing composition, and further to provide a molded article coated with a silicon oxide vapor-deposited film with high roll-off property and/or oil repellency for oils and/or fats or an oil and/or fat-containing composition.

As a result of diligent studies, the present inventors have found that by using a silicon oxide vapor-deposited film containing hydroxyl groups and alkoxy groups in a certain ratio, a coating having high roll-off property and/or oil repellency for oils and/or fats or an oil and/or fat-containing composition and a molded article having the coating can be obtained, and have completed the present invention.

That is, one aspect of the present invention may relate to the following.
[1] A silicon oxide vapor-deposited film, wherein
   a surface of the silicon oxide vapor-deposited film has a ratio of ion intensity AO to ion intensity B (ion intensity AO/ion intensity B) of 3 or more in an ion intensity spectrum obtained by time-of-flight secondary ion mass spectrometry,
   the ion intensity B is the sum of intensities of the positive ion at m/z 78.99 and the positive ion at m/z 138.95, and
   the ion intensity AO is the sum of intensities of the negative ion at m/z 31.02, the negative ion at m/z 59.00, the negative ion at m/z 74.99, the positive ion at m/z 102.97, and the negative ion at m/z 134.96.
[2] The silicon oxide vapor-deposited film according to [1], wherein
   a ratio of ion intensity AO to ion intensity A (ion intensity AO/ion intensity A) is 0.1 or more, and
   the ion intensity A is the sum of intensities of the positive ion at m/z 43.00, the positive ion at m/z 59.03, and the positive ion at m/z 73.05.
[3] The silicon oxide vapor-deposited film according to [1] or [2], wherein the silicon oxide vapor-deposited film satisfies at least one of the following conditions:
   a ratio of the sum of ion intensities A and AO to ion intensity S ((ion intensity A+ion intensity AO)/ion intensity S) is 10 or more; or
   a ratio of ion intensity AO to ion intensity S (ion intensity AO/ion intensity S) is 0.7 or more, wherein
   the ion intensity S is an intensity of the positive ion at m/z 43.97, and
   the ion intensity A is the sum of intensities of the positive ion at m/z 43.00, the positive ion at m/z 59.03, and the positive ion at m/z 73.05.
[4] The silicon oxide vapor-deposited film according to any one of [1] to [3], wherein the silicon oxide vapor-deposited film is a film derived from hexamethyldisiloxane.
[5] A molded article, having a surface coated with the silicon oxide vapor-deposited film according to any one of [1] to [4].
[6] The molded article according to [5], wherein the molded article is a container, a pipe, or a cooking utensil molded from a material selected from resin, glass, metal, ceramics, and paper.
[7] A method for producing a molded article coated with a silicon oxide vapor-deposited film, comprising a step of coating a surface of a molded article with the silicon oxide vapor-deposited film according to [5] or [6] by a plasma CVD method.

According to the present invention, a silicon oxide vapor-deposited film excellent in roll-off property and/or oil repellency for oils and/or fats or an oil and/or fat-containing composition can be provided. Also, a molded article having a surface coated with the silicon oxide vapor-deposited film is expected to allow easy removal of oil and/or fat stains and have good cleanability for oil and/or fat stains. Also, when the molded article is a container, pipe, or the like, it is also expected that oil dischargeability will be good and residue of oils and/or fats will be less likely to remain.

### Brief Description of Drawings

Fig. 1 is a photograph of Reference Example 1 after 5 days.
Fig. 2 is a photograph of Example 1 after 5 days.

### Description of Embodiments

Hereinafter, the present invention will be described in detail with examples. In the embodiments of the present invention, A (numerical value) to B (numerical value) means A or more and B or less. Note that preferred aspects, more preferred aspects, and the like exemplified below can be used in appropriate combination with each other, regardless of expressions such as "preferred" or "more preferred." Also, the description of a numerical range is an example, and a range in which the upper limit and the lower limit of each range and the numerical values of the examples are appropriately combined can also be preferably used, regardless of expressions such as "preferred" or "more preferred." Furthermore, terms such as "containing" or "including" may be appropriately read as "consisting essentially of" or "consisting of."

### [Silicon Oxide Vapor-Deposited Film]

The silicon oxide vapor-deposited film of the present invention is a silicon oxide vapor-deposited film wherein a surface of the silicon oxide vapor-deposited film has (a) a ratio of ion intensity AO to ion intensity B (ion intensity AO/ion intensity B) of 3 or more in an ion intensity spectrum obtained by time-of-flight secondary ion mass spectrometry. The silicon oxide vapor-deposited film of the present invention is preferably a silicon oxide vapor-deposited film wherein a surface of the silicon oxide vapor-deposited film has (b) a ratio of ion intensity AO to ion intensity A (ion intensity AO/ion intensity A) of 0.1 or more or 0.2 or more, and/or, (c) a ratio of the sum of ion intensities A and AO to ion intensity S ((ion intensity A+ion intensity AO)/ion intensity S) of 10 or more, and/or, (d) a ratio of ion intensity AO to ion intensity S (ion intensity AO/ion intensity S) of 0.7 or more, in an ion intensity spectrum obtained by time-of-flight secondary ion mass spectrometry. Here, ion s, ion a, ion ao, ion b, ion intensity S, ion intensity A, ion intensity AO, and ion intensity B are as follows.

Ion s refers to the positive ion at m/z 43.97.

Ion a refers to the group of positive ions consisting of the positive ion at m/z 43.00, the positive ion at m/z 59.03, and the positive ion at m/z 73.05.

Ion ao refers to the group of ions consisting of the negative ion at m/z 31.02, the negative ion at m/z 59.00, the negative ion at m/z 74.99, the positive ion at m/z 102.97, and the negative ion at m/z 134.96.

Ion b refers to the group of positive ions consisting of the positive ion at m/z 78.99, and the positive ion at m/z 138.95.

The ion intensity S is the intensity of the positive ion at m/z 43.97.

The ion intensity A is the sum of intensities of the positive ion at m/z 43.00, the positive ion at m/z 59.03, and the positive ion at m/z 73.05.

The ion intensity AO is the sum of intensities of the negative ion at m/z 31.02, the negative ion at m/z 59.00, the negative ion at m/z 74.99, the positive ion at m/z 102.97, and the negative ion at m/z 134.96.

The ion intensity B is the sum of intensities of the positive ion at m/z 78.99, and the positive ion at m/z 138.95.

Note that in the present invention, ions detected in time-of-flight secondary ion mass spectrometry are identified by m/z (a value obtained by dividing the mass m of an ion by the valence of the ion: a dimensionless quantity value). Also, the intensity of an ion (ion intensity) is a value that depends on the number of ions detected by time-of-flight secondary ion mass spectrometry (a value detected for each ion at each m/z).

The silicon oxide vapor-deposited film of the present invention can be produced by a plasma CVD method using a reactive gas containing an organosilicon compound, and it is presumed that roll-off property and/or oil repellency for oils and/or fats or an oil and/or fat-containing composition are expressed by allowing hydroxyl groups and alkoxy groups to remain in the silicon oxide vapor-deposited film at a certain ratio.

Since the content of components including hydroxyl groups and/or alkoxy groups and/or alkyl groups in the silicon oxide vapor-deposited film correlates with the intensity of peaks derived from functional groups obtained by time-of-flight secondary ion mass spectrometry (TOF-SIMS) of the surface of the silicon oxide vapor-deposited film, the silicon oxide vapor-deposited film of the present invention requires that the ion intensity of ions presumed to contain hydroxyl groups and/or alkoxy groups and/or alkyl groups be a certain ratio with respect to the ion intensity of ions presumed to be derived only from silicon oxide in time-of-flight secondary ion mass spectrometry.

Note that the ion presumed to be derived only from silicon oxide (ion s) is the positive ion at m/z 43.97 (SiO), and the ion intensity of this ion is the ion intensity S. Also, the ions presumed to contain an alkyl group (ion a) are the positive ion at m/z 43.00 (SiCH₃), the positive ion at m/z 59.03 (SiC₂H₇), and the positive ion at m/z 73.05 (SiC₃H₉), and the sum of these ion intensities is the ion intensity A. Also, the ions presumed to contain an alkoxy group (ion ao) are the negative ion at m/z 31.02 (CH₃O), the negative ion at m/z 59.00 (SiCH₃O), the negative ion at m/z 74.99 (SiCH₃O₂), the positive ion at m/z 102.97 (Si₂CH₃O₂), and the negative ion at m/z 134.96 (Si₂CH₃O₄), and the sum of these ion intensities is the ion intensity AO. Furthermore, the ions presumed to contain a hydroxyl group (ion b) are the positive ion at m/z 78.99 (SiO₃H₃), and the positive ion at m/z 138.95 (Si₂O₅H₃), and the sum of these ion intensities is the ion intensity B.

The silicon oxide vapor-deposited film of the present invention is a silicon oxide vapor-deposited film in which (a) the ratio of ion intensity AO to ion intensity B (ion intensity AO/ion intensity B) at a surface of the film is 3 or more, preferably 6 or more, more preferably 8 or more, still more preferably 12 or more, and particularly preferably 14 or more, in an ion intensity spectrum obtained by time-of-flight secondary ion mass spectrometry. The silicon oxide vapor-deposited film of the present invention is preferably a silicon oxide vapor-deposited film in which, in the ion intensity spectrum obtained by time-of-flight secondary ion mass spectrometry of the surface of the silicon oxide vapor-deposited film, (b) the ratio of ion intensity AO to ion intensity A (ion intensity AO/ion intensity A) is 0.1 or more or 0.2 or more, may be preferably 1.8 or more or 1.9 or more, and is more preferably 2.0 or more. As another aspect, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (c) the ratio of the sum of ion intensities A and AO to ion intensity S ((ion intensity A+ion intensity AO)/ion intensity S) is 10 or more, may be preferably 20 or more, is more preferably 30 or more, and is still more preferably 33 or more.

Also, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (a)' the ratio of ion intensity AO to ion intensity B (ion intensity AO/ion intensity B) is preferably 20,000 or less or 14,000 or less, and is more preferably any one of 500 or less, 200 or less, 100 or less, 50 or less, or 40 or less. Also, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (b)' the ratio of ion intensity AO to ion intensity A (ion intensity AO/ion intensity A) is preferably 5 or less, and more preferably 3 or less or 1 or less. Also, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (c)' the ratio of the sum of ion intensities A and AO to ion intensity S ((ion intensity A+ion intensity AO)/ion intensity S) is preferably 60,000 or less or 45,000 or less, more preferably 1,000 or less or 600 or less, still more preferably 100 or less, and particularly preferably 80 or less.

As another aspect, the silicon oxide vapor-deposited film of the present invention is a silicon oxide vapor-deposited film in which, in an ion intensity spectrum obtained by time-of-flight secondary ion mass spectrometry of the surface of the silicon oxide vapor-deposited film, (d) the ratio of ion intensity AO to ion intensity S (ion intensity AO/ion intensity S) may be 0.7 or more, is preferably 0.8 or more, more preferably 1 or more, still more preferably 5 to 500, and particularly preferably 7 to 250.

Also, regarding ion intensity, it is preferable that (e) a ratio of ion intensity A to ion intensity S (ion intensity A/ion intensity S) is 5 or more, more preferably 6 or more, still more preferably 7 or more, and particularly preferably 40 or more.

Here, the conditions of the above (a) to (e) and (c)' may satisfy or not satisfy one or more of the conditions of (b) to (e) and (a)' to (c)' in combination, as long as (a) is satisfied.

Note that in the present invention, time-of-flight secondary ion mass spectrometry can be measured using a commercially available apparatus, and for example, a time-of-flight secondary ion mass spectrometer ("TOF.SIMS5" manufactured by ION-TOF GmbH, Germany, measurement area: 500 µm square, primary ion source: Bi) sold by Hitachi High-Tech Science Corporation can be used.

In the silicon oxide vapor-deposited film of the present invention, since roll-off property and/or oil repellency for oils and/or fats or an oil and/or fat-containing composition can be achieved by covering the surface, the thickness of the film is considered not to have a particular influence. The thickness of the film is not particularly limited, but is preferably 1 to 800 nm, more preferably 5 to 500 nm, still more preferably 8 to 400 nm, even more preferably 10 to 300 nm, and most preferably 10 to 150 nm.

The thickness of the silicon oxide vapor-deposited film can be measured, for example, with a microscopic automatic film thickness measurement system (model number: F54 XY 200UV) manufactured by Filmetrics, Inc., a stylus-type film thickness meter "DEKTAK" manufactured by Bruker Corporation, or by preparing a cross-section of the film and using a field emission scanning electron microscope "JSM-7800F Prime" (magnification 30,000x, acceleration voltage 2 kV, working distance 10.3 mm) manufactured by JEOL Ltd.

### [Molded Article]

The molded article of the present invention is a molded article having a surface coated with the aforementioned silicon oxide vapor-deposited film. The surface coating may be on all or part of the inner and outer surfaces of the molded article, but from the viewpoint of dischargeability of the contents, it preferably refers to the coating on the inner surface of the molded article. Note that the aforementioned surface means the outermost layer of the molded article. Also, in the silicon oxide vapor-deposited film of the present invention, another coating may be present between the substrate of the coated molded article and the coating layer according to the present invention.

The molded article (substrate) of the present invention is preferably molded from a material selected from the group consisting of resin, glass, metal, and paper. By providing the aforementioned silicon oxide vapor-deposited film on the surface of the molded article, a molded article endowed with prevention of oil stains and improvement in oil removability can be obtained. Suitable resins include thermoplastic resins known per se, for example, low-density polyethylene, high-density polyethylene, polypropylene, poly-1-butene, poly-4-methyl-1-pentene, polyolefins (for example, polyolefins such as random or block copolymers of α-olefins such as ethylene, propylene, 1-butene, 4-methyl-1-pentene), ethylene-vinyl compound copolymers (for example, ethylene-vinyl acetate copolymer, ethylene-vinyl alcohol copolymer, ethylene-vinyl chloride copolymer, and the like), styrenic resins (for example, polystyrene, acrylonitrile-styrene copolymer, ABS, α-methylstyrene-styrene copolymer, and the like), polyvinyl compounds (for example, polyvinyl chloride, polyvinylidene chloride, vinyl chloride-vinylidene chloride copolymer, polymethyl acrylate, polymethyl methacrylate, and the like), polyamides (for example, nylon 6, nylon 6-6, nylon 6-10, nylon 11, nylon 12, and the like), thermoplastic polyesters (for example, polyethylene terephthalate, polybutylene terephthalate, polyethylene naphthalate, and the like), polycarbonate, polyphenylene oxide, biodegradable resins such as polylactic acid, or any mixture thereof. More preferably, it is a resin such as polyethylene or polyethylene terephthalate. Also, as the metal, one or more metals selected from iron, nickel, copper, zinc, lead, aluminum, chromium, titanium, and the like, or an alloy containing one or more of these metals as a main component is preferable, and stainless steel is more preferable.

These molded articles may be films, sheets, pipes, containers, or the like, and may also be cooking utensils. Pipes include tubes, valves, nozzles, and the like. Containers include bottles, tanks, cups, bags, dishes, and the like, as well as caps, nozzles, and the like that constitute a container. Cooking utensils include strainers, nets, stoves, microwave ovens, and the like, as well as ventilation fans, countertops, and the like attached to a kitchen. In particular, molded articles such as bottles, tanks, valves, and nozzles for oils and/or fats are preferable. Also, the oils and/or fats are preferably edible. Note that the portion of the molded article to be coated with the silicon oxide vapor-deposited film may be the whole or a part of the molded article, and in particular, may be only the surface portion that comes into contact with oils and/or fats or an oil and/or fat-containing composition.

In the molded article of the present invention, the contact angle of refined rapeseed oil at 20°C on the surface covered with the aforementioned silicon oxide vapor-deposited film is preferably 25° or more, more preferably 30 to 70°, still more preferably 35 to 60°, and most preferably 33 to 55°.

### (Roll-off property of Oils and/or Fats or an Oil and/or Fat-Containing Composition)

In the molded article of the present invention, the roll-off property of oils and/or fats or an oil and/or fat-containing composition measured under the following conditions on the surface covered with the aforementioned silicon oxide vapor-deposited film is, for example, 300 seconds or less, preferably 60 seconds or less, more preferably 20 seconds or less, still more preferably 10 seconds or less, and the shorter the time, the more preferable. For example, it can be determined that the roll-off property of oils and/or fats or an oil and/or fat-containing composition is classified as good in the following order: more than 60 to 300 seconds, more than 20 to 60 seconds, more than 10 to 20 seconds, and 10 seconds or less.

Roll-off property of oils and/or fats or an oil and/or fat-containing composition: time (seconds) for the rear end of an oil and/or fat droplet (or liquid droplet) such as rapeseed oil of 24±0.5 mg to move 6 mm on the sample surface inclined at 70° with respect to the vertical at 23±3°C.

Here, the roll-off property may be measured for oils and/or fats or any product containing oils and/or fats (oil and/or fat-containing composition). In this specification, the term "oil" may mean not only oil, but also oils and/or fats and any product containing oils and/or fats (oil and/or fat-containing composition). For example, "oil" in "oil drainage" or "oil repellency" may mean the oil repellency of the oil component in an oil and/or fat-containing composition, not only oil or oils and/or fats. The "oil and/or fat-containing composition" is preferably, for example, liquid or fluid at 20°C. The oil repellency of an oil and/or fat-containing composition such as a dressing may be evaluated by the amount of the oil and/or fat-containing composition discharged from a container (amount of residual liquid). Furthermore, in this specification, "oil", "oils and/or fats," and "oil and/or fat-containing composition" may be interchanged with each other.

The measurement is performed with reference to the rear end of an oil and/or fat droplet (or liquid droplet) such as rapeseed oil, wherein the rear end is defined as the uppermost point of contact between the sample surface and the oil and/or fat droplet (or liquid droplet) on the inclined sample surface. The rapeseed oil may be dropped onto the sample surface inclined at 70° with respect to the vertical, but may also be measured by dropping it onto a horizontally placed sample surface and then inclining it to 70° with respect to the vertical. The sample to be measured is a container for storing oils and/or fats or an oil and/or fat-containing composition, and may be measured as it is, or a smooth part of the container for storing the oils and/or fats or an oil and/or fat-containing composition to be measured may be cut out and measured as a flat or substantially flat sample. As a method for inclining the sample to 70° with respect to the vertical, a known method can be used, but for example, "Stage AG85 (angle tilt)" manufactured by AS ONE Corporation or the like may be used.

As the oils and/or fats dropped onto the sample surface of the container for storing oils and/or fats or an oil and/or fat-containing composition, animal and vegetable oils and/or fats, mineral oils and/or fats, and the like can be used. Animal and vegetable oils and/or fats include liquid oils, solid fats, and semi-solid fats, and a specific example of a liquid oil of animal and vegetable oils and/or fats is rapeseed oil. As rapeseed oil, a refined one can be used, and rapeseed oil sold for food or rapeseed oil sold as a reagent can be used. As rapeseed oil sold for food, one categorized as "refined rapeseed oil" or "rapeseed salad oil" in "edible rapeseed oil" of the JAS standard ("Japanese Agricultural Standard for Edible Vegetable Oils and Fats," Ministry of Agriculture, Forestry and Fisheries Notification No. 681 of August 19, 2019) can be used. For example, "Nisshin Canola Oil" (manufactured by The Nisshin OilliO Group, Ltd.) or the like can be used. Also, as a reagent, "Rapeseed Oil" (manufactured by Fujifilm Wako Pure Chemical Corporation: Wako 1^{st} Grade) or the like can be used. Note that an oil-soluble coloring agent may be added to improve the visibility of the rapeseed oil. For example, about 0.1% by mass of β-carotene can be added to the rapeseed oil. The addition of this amount of β-carotene does not substantially affect the roll-off property value of the oil and/or fat itself (the roll-off property value of the oil and/or fat does not substantially change with or without β-carotene). Refined rapeseed oil usually contains 51 to 66% by mass of oleic acid, 19 to 28% by mass of linoleic acid, 2 to 11% by mass of linolenic acid, 3 to 6% by mass of palmitic acid, and 1 to 3% by mass of stearic acid. The amount of the mixture of the above oils dropped is 24±0.5 mg, and is preferably about 24.36 mg, which corresponds to one drop from a commercially available dropper. Also, when an oil and/or fat-containing composition is stored in a container, various compositions containing oil or oils and/or fats, such as emulsified dressings (including mayonnaise and mayonnaise-type dressings) and separated dressings, may be used instead of oil, and the roll-off property may be measured in the same manner as above. As liquid oils of animal and vegetable oils and/or fats, soybean oil, corn oil, sunflower oil, linseed oil, olive oil, and the like can also be mentioned. As solid fats and semi-solid fats of animal and vegetable oils and/or fats, palm-derived oils and/or fats, hydrogenated oils of animal and vegetable oils and/or fats, and the like can be mentioned. Liquid oils, solid fats, and semi-solid fats of mineral oils and/or fats can also be used, and as liquid oils of mineral oils and/or fats, liquid paraffin (paraffin oil), naphthenic oil, diesel oil, gasoline, heavy oil, and the like can be mentioned. As solid fats of mineral oils and/or fats, paraffin wax and the like can be mentioned.

### [Method for Producing Molded Article]

The molded article of the present invention is produced by coating a molded article with a silicon oxide vapor-deposited film by a plasma CVD method using an organosilicon compound and an optional oxidizing gas as a reaction gas.

### (Organosilicon Compound and Oxidizing Gas)

In the method for producing a molded article of the present invention, an organosilicon compound is used as a silicon source for forming a silicon oxide vapor-deposited film. As the organosilicon compound, organic silane compounds (for example, hexamethyldisilane, vinyltrimethylsilane, methylsilane, dimethylsilane, tetramethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane, and methyltriethoxysilane, and the like), and organic siloxane compounds (for example, octamethylcyclotetrasiloxane, 1,1,3,3-tetramethyldisiloxane, hexamethyldisiloxane, and the like), diethoxydimethylsilane, dimethoxydimethylsilane, and the like are used. Also, in addition to these materials, silazanes such as hexamethyldisilazane, aminosilanes, and the like can also be used. These organosilicon compounds can be used alone or in combination of two or more. Also, silane (SiH₄) or silicon tetrachloride can be used in combination with the aforementioned organosilicon compounds. Regarding the organic functional group possessed by the organosilicon compound, an organosilicon compound having a functional group selected from a methyl group, a methoxy group, an ethyl group, and an ethoxy group is preferable; an organosilicon compound having an ethoxy group and/or a methoxy group is more preferable; and an organosilicon compound having only an ethoxy group is still more preferable. Furthermore, an organosilicon compound having only a methyl group is also particularly preferable. Tetraethoxysilane, tetramethoxysilane, hexamethyldisilazane, hexamethyldisiloxane, and the like are preferable, and only hexamethyldisiloxane or an organosilicon compound containing hexamethyldisiloxane is more preferable. Note that it is preferable that the organosilicon compound does not contain fluorine.

As the oxidizing gas, oxygen or NOx is used, and oxygen is preferable. Note that a noble gas such as argon or helium is used as a carrier gas or a gas for stabilizing discharge.

In the method for producing a molded article of the present invention, it is preferable to coat the molded article with a silicon oxide vapor-deposited film by a plasma CVD method in which a ratio of a flow rate (volume) of the oxidizing gas to a total flow rate (volume) of the reaction gas is 0 to 95 vol%. By setting such conditions, a silicon oxide vapor-deposited film particularly excellent in roll-off property and/or oil repellency for oils and/or fats or an oil and/or fat-containing composition can be obtained. The ratio of the flow rate (volume) of the oxidizing gas to the total flow rate (volume) of the reaction gas is more preferably 1 to 65 vol% or 0 to 60 vol%, still more preferably 2 to 40 vol% or 0 to 30 vol%, and most preferably 5 to 10 vol%. Note that the flow rate of the reaction gas depends on the coating area in the molded article to be treated, but for example, when coating the inner surface of a plastic container with a capacity of 200 mL to 1.5 L, it is preferably supplied at a flow rate of 3 to 2000 sccm, particularly 5 to 600 sccm per container. Note that "sccm" means the amount of gas (cc or ml) flowing per minute at 0°C and 1 atmosphere.

### (Plasma CVD Method)

In the present invention, plasma treatment by a plasma CVD method is performed on the surface of a substrate held in a plasma treatment chamber in an atmosphere containing the aforementioned organosilicon compound, an optional oxidizing gas, and a carrier gas as necessary, to form a vapor-deposited film with the aforementioned composition.

During the plasma treatment, in order to maintain the plasma treatment chamber at a degree of vacuum where a glow discharge occurs, the pressure during film formation is preferably 1 to 200 Pa, and more preferably 3 to 100 Pa. In this state, a silicon oxide vapor-deposited film is formed by glow discharge by supplying microwaves (300 MHz to 300 GHz), high frequencies (1 to 300 MHz), or the like. For example, the output of microwaves is preferably in a range of 10 to 1000 W, and more preferably 20 to 1000 W. The frequency of microwaves is preferably 500 MHz to 30 GHz, and more preferably 1 to 10 GHz. The output of high frequencies is preferably 20 to 1500 W, and more preferably 30 to 1500 W. The frequency of high frequencies is preferably 1 to 100 MHz, more preferably 1 to 30 MHz, and still more preferably 10 to 15 MHz.

Note that in the method for producing a molded article of the present invention, it is sufficient that the outermost layer of the molded article is a silicon oxide vapor-deposited film coated under the above conditions, and a molded article coated under other conditions may be further coated under the above production conditions. Also, the conditions of the plasma CVD method may be changed, such as by changing the supply amount of the oxidizing gas, and the coating may be finally performed under the above production conditions.

### Examples

Next, the present invention will be described in more detail by giving Examples, Comparative Examples, and Reference Examples, but the present invention is not limited thereto in any way. Also, hereinafter, "%" indicates % by mass unless otherwise specified.

Note that in the tables, "(A+AO)/S" means "(ion intensity A+ion intensity AO)/ion intensity S," "A/S" means "ion intensity A/ion intensity S," "AO/S" means "ion intensity AO/ion intensity S," "AO/A" means "ion intensity AO/ ion intensity A," and "AO/B" means "ion intensity AO/ ion intensity B."

### [Analysis Method]

### (Surface Functional Group Analysis)

Using a time-of-flight secondary ion mass spectrometer ("TOF.SIMS5" sold by Hitachi High-Tech Science Corporation, acceleration voltage: 30 kV, measurement area: 500 µm square, primary ion source: Bi (bismuth)), the surfaces of the silicon oxide vapor-deposited film samples of the Examples and Comparative Examples were analyzed. From the ion intensities of the obtained peaks, the ratio of the sum of ion intensity A and ion intensity AO to ion intensity S ((ion intensity A+ion intensity AO)/ion intensity S), the ratio of ion intensity A to ion intensity S (ion intensity A/ion intensity S), the ratio of ion intensity AO to ion intensity S (ion intensity AO/ion intensity S), the ratio of ion intensity AO to ion intensity A (ion intensity AO/ion intensity A), and the ratio of ion intensity AO to ion intensity B (ion intensity AO/ion intensity B) were calculated.

Note that the intensity of an ion (ion intensity) mentioned here is a value that depends on the number of ions detected by time-of-flight secondary ion mass spectrometry (a value detected for each ion at each m/z). The ion intensity S was taken as the intensity of the positive ion at m/z 43.97, the ion intensity A was taken as the sum of the intensities of the positive ion at m/z 43.00, the positive ion at m/z 59.03, and the positive ion at m/z 73.05, the ion intensity AO was taken as the sum of the intensities of the negative ion at m/z 31.02, the negative ion at m/z 59.00, the negative ion at m/z 74.99, the positive ion at m/z 102.97, and the negative ion at m/z 134.96, and the ion intensity B was taken as the sum of the intensities of the positive ion at m/z 78.99 and the positive ion at m/z 138.95.

### (Contact Angle)

Using a contact angle meter ("DMo-502" manufactured by Kyowa Interface Science Co., Ltd.), the measurement was performed with the setting of "Contact Angle Measurement [Sessile Drop Method]" in the contact angle meter. The liquid used for the measurement of the contact angle was refined rapeseed oil ("Nisshin Canola Oil" manufactured by The Nisshin OilliO Group, Ltd.), and the liquid volume used for one measurement was 2.0 µL. Note that for the supply of oil in the contact angle meter, a "Teflon (registered trademark) coated needle" (manufactured by Kyowa Interface Science Co., Ltd.) was used. Since oil has a high viscosity and spreads by wetting over time after being placed on the surface of the silicon oxide vapor-deposited film samples of the Examples and Comparative Examples, the value at 50 seconds after liquid placement, when the contact angle became somewhat stable, was recorded.

For the analysis, the θ/2 method (calculating the radius r and height h of the liquid droplet by image processing, and calculating θ = 2arctan(h/r)) was used.

### (Roll-off property of Oils and/or Fats)

The containers for storing oils and/or fats of the Examples and Comparative Examples (container samples) were placed horizontally, and from the opening of the container, one drop (about 24.36 mg) of refined rapeseed oil ("Nisshin Canola Oil" manufactured by The Nisshin OilliO Group, Ltd., 99.9%) colored with carotene ("β-Carotene 30% FS" manufactured by DMS, 0.1%) was dropped onto the flat part of the container with a dropper. Immediately, the sample was placed on a stage ("Stage (angle tilt)" manufactured by AS ONE Corporation) set at an inclination of 70° with respect to the vertical, and the time for the rear end of the oil and/or fat droplet (the uppermost point of contact between the sample surface and the oil and/or fat droplet) to move 6 mm on the sample surface was measured. Note that the temperature during the measurement was room temperature (23°C).

Based on the movement time, an evaluation was performed based on the following criteria of A to E, and if it was A to D, the evaluation sample was considered to have roll-off property and/or oil repellency for oils and/or fats. Also, here, it can be determined that the shorter the movement time, the higher and better the roll-off property and/or oil repellency for oils and/or fats.
Evaluation A: no more than 10 seconds
Evaluation B: more than 10 seconds to 20 seconds
Evaluation C: more than 20 seconds to 60 seconds
Evaluation D: more than 60 seconds to 300 seconds
Evaluation E: more than 300 seconds

### [Comparative Examples and Examples]

### (Plasma CVD Apparatus)

The film formation conditions by the plasma CVD apparatus used in the Comparative Examples and Examples are as shown in Table 1-1, Table 2-1, Table 3-1, and Table 4-1. Also, the settings of the plasma CVD apparatus other than those in Table 1-1, Table 2-1, Table 3-1, and Table 4-1 are as follows.
Name: Plasma CVD apparatus
Film formation method: PECVD (Plasma Enhanced Chemical Vapor Deposition)
Plasma source: CCP (Capacitively Coupled Plasma)
Electrode shape: Conformal type (conforming to the container shape)
External RF electrode: Upper and lower 2-piece structure, no cooling mechanism
Internal gas introduction electrode: φ6.35 mm, no heating mechanism
Material: Aluminum alloy (external electrode), SUS304 (internal electrode)
RF power supply: Frequency 13.56 MHz
RF switcher: For 2ch
Matching method: Automatic impedance matching
Exhaust configuration: Mechanical booster pump (main exhaust), Rotary pump (auxiliary)
Exhaust manifold external dimensions: 350 mm x 350 mm x H150 mm

### (Preparation of Silicon Oxide Vapor-Deposited Film and Molded Article)

Using a plasma CVD apparatus (details above), plasma treatment was performed on an uncoated commercially available polyethylene terephthalate container for edible oils and/or fats (PET container: usable capacity 600 g, inner diameter of the upper opening 27.6 mm, height 218.7 mm) under the film formation conditions of Table 1-1, Table 2-1, Table 3-1, and Table 4-1 to coat the PET container with a silicon oxide vapor-deposited film, thereby obtaining container samples (samples of containers for storing oils and/or fats) of Comparative Examples 2 to 3 and Examples 1 to 15. Also, a commercially available container of the same shape as the PET container coated with a silicon oxide vapor-deposited film was designated as Comparative Example 1.

Specifically, for the container samples of Comparative Examples 2 to 3 and Examples 1 to 15, tetraethoxysilane (hereinafter referred to as TEOS), tetramethoxysilane (hereinafter referred to as TMOS), hexamethyldisilazane (hereinafter referred to as HMDSN), or hexamethyldisiloxane (hereinafter referred to as HMDSO) was used as an organosilicon compound. If necessary, oxygen (O₂) was mixed with the organosilicon compound as an oxidizing gas and used as a reaction gas. Also, if necessary, helium (He) was used as a carrier gas for TEOS, and argon (Ar) was used as a gas for stabilizing discharge. First, the PET container was set in the plasma treatment chamber of the plasma CVD apparatus, and after reducing the pressure in the plasma treatment chamber to 1 Pa or less, the reaction gas and optionally the carrier gas and the gas for stabilizing discharge were introduced into the plasma treatment chamber at the flow rates described in Table 1-1, Table 2-1, Table 3-1, Table 4-1, and Table 5-1, and after stabilizing the pressure at the pressure described in Table 1-1, Table 2-1, Table 3-1, Table 4-1, and Table 5-1 over 30 seconds to 60 seconds, discharge was performed for the duration described in Table 1-1, Table 2-1, Table 3-1, Table 4-1, and Table 5-1 with the plasma power described in Table 1-1, Table 2-1, Table 3-1, Table 4-1, and Table 5-1 to coat the surface of the PET container with a silicon oxide vapor-deposited film. After the discharge, the introduction of the reaction gas and the optional carrier gas and the gas for stabilizing discharge was stopped, and after reducing the pressure in the film formation chamber to 1 Pa or less, the plasma treatment chamber was vented to the atmosphere, and the PET container was taken out from the plasma treatment chamber.

From the flat part of the PET container coated with the silicon oxide vapor-deposited film as described above, a 2 cm square PET plate was cut out to obtain an evaluation sample, and the ion intensities and ratios thereof, and the roll-off property of oils and/or fats were analyzed and evaluated as described above. The analysis and evaluation results are shown in Table 1-2, Table 2-2, Table 3-2, Table 4-2, and Table 5-2.

| Table 1-1 | Comparative Example 1 | Comparative Example 2 | Comparative Example 3 |
|---|---|---|---|
| Raw material | - | HMDSO | TEOS |
| Raw material flow rate [sccm] | - | 10 | 10.8 |
| Oxygen flow rate [sccm] | - | 50 | 50 |
| Ar flow rate [sccm] | - | 0 | 0 |
| He flow rate [sccm] | - | 0 | 100 |
| Pressure [Pa] | - | 10 | 10 |
| Plasma power [W] | - | 1000 | 1000 |
| Time [seconds] | - | 2 | 3 |

| Table 1-2 | Comparative Example 1 | Comparative Example 2 | Comparative Example 3 |
|---|---|---|---|
| Intensity of AO | 3469 | 7075 | 642 |
| Intensity of A | 51343 | 52010 | 12127 |
| Intensity of B | 7194 | 8427 | 14774 |
| Intensity of S | 14435 | 9751 | 10050 |
| AO/B | 0.5 | 0.8 | 0.04 |
| AO/A | 0.07 | 0.1 | 0.05 |
| (A+AO)/S | 3.8 | 6.1 | 1.3 |
| AO/S | 0.2 | 0.7 | 0.1 |
| A/S | 3.56 | 5.3 | 1.2 |
| Contact angle (°) | 11.8 | 22.9 | 18.7 |
| Roll-off property of oils and/or fats (seconds) | >300 | >300 | >300 |
| Evaluation | E | E | E |

| Table 2-1 | Example 1 | Example 2 | Example 3 | Example 4 | Example 5 |
|---|---|---|---|---|---|
| Raw material | HMDSO | HMDSO | HMDSO | HMDSO | HMDSO |
| Raw material flow rate [sccm] | 10 | 20 | 40 | 40 | 50 |
| Oxygen flow rate [sccm] | 0 | 200 | 0 | 100 | 500 |
| Ar flow rate [sccm] | 50 | 0 | 50 | 0 | 0 |
| He flow rate [sccm] | 0 | 0 | 0 | 0 | 0 |
| Pressure [Pa] | 50 | 10 | 5 | 20 | 30 |
| Plasma power [W] | 100 | 300 | 300 | 666 | 1000 |
| Time [seconds] | 10 | 10 | 10 | 3 | 2 |

| Table 2-2 | Example 1 | Example 2 | Example 3 | Example 4 | Example 5 |
|---|---|---|---|---|---|
| Intensity of AO | 39829 | 28459 | 43355 | 51027 | 36074 |
| Intensity of A | 310300 | 63693 | 182043 | 125082 | 76267 |
| Intensity of B | 3 | 2442 | 127 | 453 | 1413 |
| Intensity of S | 9 | 19890 | 245 | 722 | 1423 |
| AO/B | 13276.3 | 11.7 | 341.4 | 112.6 | 25.5 |
| AO/A | 0.13 | 0.45 | 0.24 | 0.41 | 0.47 |
| (A+AO)/S | 41191.6 | 46.3 | 920.0 | 243.9 | 79.0 |
| AO/S | 4685.8 | 14.3 | 177.0 | 70.7 | 25.4 |
| A/S | 36505.8 | 32.0 | 743.0 | 173.2 | 53.6 |
| Contact angle (°) | 53.6 | 43.4 | 45.5 | 42.0 | 45.4 |
| Roll-off property of oils and/or fats (seconds) | 5 | 11 | 6 | 8 | 7 |
| Evaluation | A | B | A | A | A |

| Table 3-1 | Example 6 | Example 7 | Example 8 |
|---|---|---|---|
| Raw material | TMOS | TMOS | TMOS |
| Raw material flow rate [sccm] | 10 | 60 | 60 |
| Oxygen flow rate [sccm] | 0 | 0 | 0 |
| Ar flow rate [sccm] | 0 | 0 | 0 |
| He flow rate [sccm] | 0 | 0 | 0 |
| Pressure [Pa] | 20 | 10 | 50 |
| Plasma power [W] | 100 | 100 | 500 |
| Time [seconds] | 10 | 10 | 4 |

| Table 3-2 | Example 6 | Example 7 | Example 8 |
|---|---|---|---|
| Intensity of AO | 28278 | 31829 | 28787 |
| Intensity of A | 9615 | 13243 | 10257 |
| Intensity of B | 1679 | 1764 | 1946 |
| Intensity of S | 1503 | 1298 | 1809 |
| AO/B | 16.8 | 18.0 | 14.8 |
| AO/A | 2.94 | 2.40 | 2.81 |
| (A+AO)/S | 25.2 | 34.7 | 21.6 |
| AO/S | 18.8 | 24.5 | 15.9 |
| A/S | 6.4 | 10.2 | 5.7 |
| Contact angle (°) | 38.7 | 38.7 | 38.8 |
| Roll-off property of oils and/or fats (seconds) | 6 | 6 | 6 |
| Evaluation | A | A | A |

| Table 4-1 | Example 9 | Example 10 | Example 11 | Example 12 |
|---|---|---|---|---|
| Raw material | TMOS | TMOS | TMOS | HMDSN |
| Raw material flow rate [sccm] | 10 | 60 | 60 | 10 |
| Oxygen flow rate [sccm] | 0 | 0 | 0 | 40 |
| Ar flow rate [sccm] | 0 | 0 | 0 | 0 |
| He flow rate [sccm] | 0 | 0 | 0 | 0 |
| Pressure [Pa] | 10 | 30 | 20 | 10 |
| Plasma power [W] | 100 | 500 | 500 | 1000 |
| Time [seconds] | 10 | 4 | Total 4^{*1} | 10 |

| | | | | |
|---|---|---|---|---|
| *1: Treatment for 2 seconds was performed twice. | | | | |

| Table 4-2 | Example 9 | Example 10 | Example 11 | Example 12 |
|---|---|---|---|---|
| Intensity of AO | 30036 | 28026 | 18573 | 27479 |
| Intensity of A | 15008 | 10387 | 10916 | 72828 |
| Intensity of B | 2462 | 1989 | 3732 | 683 |
| Intensity of S | 1537 | 1772 | 2022 | 845 |
| AO/B | 12.2 | 14.1 | 5.0 | 40.2 |
| AO/A | 2.00 | 2.70 | 1.70 | 0.38 |
| (A+AO)/S | 29.3 | 21.7 | 14.6 | 118.8 |
| AO/S | 19.5 | 15.8 | 9.2 | 32.5 |
| A/S | 9.8 | 5.9 | 5.4 | 86.2 |
| Contact angle (°) | 38.2 | 36.5 | 33.7 | 38.5 |
| Roll-off property of oils and/or fats (seconds) | 7 | 10 | 48 | 10 |
| Evaluation | A | A | C | A |

| | | | |
|---|---|---|---|
| 0052] | | | |

| Table 5-1 | Example 13 | Example 14 | Example 15 |
|---|---|---|---|
| Raw material | HMDSO | HMDSO | HMDSO |
| Raw material flow rate [sccm] | 50 | 50 | 10 |
| Oxygen flow rate [sccm] | 50 | 0 | 0 |
| Ar flow rate [sccm] | 0 | 50 | 50 |
| He flow rate [sccm] | 0 | 0 | 0 |
| Pressure [Pa] | 30 | 30 | 10 |
| Plasma power [W] | 100 | 1000 | 500 |
| Time [seconds] | 10 | 2 | 4 |

| Table 5-2 | Example 13 | Example 14 | Example 15 |
|---|---|---|---|
| Intensity of AO | 63565 | 35104 | 37262 |
| Intensity of A | 204187 | 162715 | 83065 |
| Intensity of B | 223 | 117 | 27 |
| Intensity of S | 585 | 189 | 203 |
| AO/B | 285.7 | 198.3 | 1380.1 |
| AO/A | 0.31 | 0.22 | 0.45 |
| (A+AO)/S | 457.7 | 1046.7 | 594.2 |
| AO/S | 108.7 | 185.7 | 184.0 |
| A/S | 349.0 | 860.9 | 410.2 |
| Contact angle (°) | 59.1 | 41.7 | 31.2 |
| Roll-off property of oils and/or fats (seconds) | 8 | 11 | 21 |
| Evaluation | A | B | C |

In Comparative Examples 1 to 3, regarding the roll-off property of oils and/or fats, the movement of 6 mm of the rear end was not complete even after 300 seconds had elapsed. On the other hand, the evaluation samples of Examples 1 to 15 had better roll-off property of oils and/or fats than the evaluation samples of Comparative Examples 1 to 3. From this, it can be confirmed that the roll-off property of oils and/or fats and/or oil repellency of the evaluation samples of Examples 1 to 15 are high. In particular, the roll-off property of oils and/or fats and/or oil repellency of the evaluation samples of Examples 1, 3 to 10, and 12 to 13 were excellent. Note that the contact angles (33.7 to 53.6°) of the evaluation samples of Examples 1 to 12 were larger than the contact angles (11.8 to 22.9°) of the evaluation samples of Comparative Examples 1 to 3, and those with a large contact angle are expected to have a certain degree of roll-off property of oils and/or fats. However, while samples evaluated as A for roll-off property of oils and/or fats had contact angles of 36.5 to 53.6°, there was also one with a contact angle of 43.4° that had an evaluation of B for roll-off property of oils and/or fats. Thus, within the range where roll-off property can be expected, the contact angle and the roll-off property of oils and/or fats do not necessarily correlate.

### (Evaluation using Emulsified Dressing and Separated Dressing)

### <Evaluation Sample>

The uncoated commercially available polyethylene terephthalate container for edible oils and/or fats used in the section "Preparation of Silicon Oxide Vapor-Deposited Film and Molded Article" above (PET container: usable capacity 600 g, inner diameter of the upper opening 27.6 mm, height 218.7 mm) was designated as Reference Example 1.

Using the coated polyethylene terephthalate container for edible oils and/or fats of Example 1 above and the uncoated commercially available polyethylene terephthalate container for edible oils and/or fats of Reference Example 1, the roll-off property, residual liquid amount, and cleanability of an emulsified dressing (commercial product name "Nisshin Dressing Diet Maroyaka Goma Fumi," manufactured by The Nisshin OilliO Group, Ltd.: 12% by mass of oils and/or fats (as liquid oil)) and a separated dressing (commercial product name "Nisshin Dressing Diet Umakuchi Wafu," manufactured by The Nisshin OilliO Group, Ltd.: 12% by mass of oils and/or fats (as liquid oil)) were analyzed and evaluated as follows.

### [Analysis Method]

### (Roll-off property of Dressing)

A 2 cm square PET plate was cut out from the flat part of the container for storing an oil and/or fat-containing composition of the Example and Reference Example (container sample) to obtain an evaluation sample, and one drop of a predetermined dressing (about 48 mg for emulsified dressing, about 40 mg for separated dressing) was dropped onto the surface of the evaluation sample with a dropper. Immediately after dropping, the sample was placed on a stage ("Stage (angle tilt)" manufactured by AS ONE Corporation) set at an inclination of 70° for the emulsified dressing and 40° for the separated dressing with respect to the vertical, and the time for the rear end of the liquid droplet (the uppermost point of contact between the sample surface and the oil and/or fat droplet) to move 6 mm on the evaluation sample surface was measured. Note that the temperature during the measurement was room temperature (23°C).

Based on the movement time, an evaluation was performed based on the following criteria of A to E, and if it was A to D, the evaluation sample was considered to have a roll-off property and/or oil repellency for the oil and/or fat-containing composition. Also, here, it can be determined that the shorter the movement time, the higher and better the roll-off property and/or liquid repellency of the dressing.
Evaluation A: no more than 10 seconds
Evaluation B: more than 10 seconds to 20 seconds
Evaluation C: more than 20 seconds to 60 seconds
Evaluation D: more than 60 seconds to 300 seconds
Evaluation E: more than 300 seconds

### (Residual Liquid Amount)

After measuring the mass of the containers (empty container samples) of Reference Example 1 and Example 1, 600 g of the emulsified dressing or separated dressing was filled. The container was quickly inclined to an angle of 160° with respect to the vertical to discharge the inner solution (filled dressing). The time when the inner solution began discharging from the upper opening of the container was defined as 0 seconds, and after 300 seconds had elapsed, the container was returned to the original position, and the amount of the inner solution remaining in the container (residual liquid amount) was measured. The test was conducted at room temperature (23°C).

### (Cleanability)

After measuring the mass of the containers (empty container samples) of Reference Example 1, Example 1, and Example 15, 600 g of the emulsified dressing or separated dressing was filled. The container was quickly inclined to an angle of 160° with respect to the vertical to discharge the inner solution (filled dressing). The time when the inner solution began discharging from the upper opening of the container was defined as 0 seconds, and after 60 seconds had elapsed, the container was returned to the original position and the amount of the inner solution remaining in the container (residual liquid amount) was measured.

Thereafter, 50 g of tap water was added to the sample, and after inverting it vertically twice for each of the four sides, for a total of 8 inversions (washing), it was allowed to stand at 60°C for 24 hours to evaporate the water (drying), and the residual liquid amount after washing and drying was measured. Each test was conducted at room temperature (23°C).

**Table 6**

| | Emulsified Dressing | | Separated Dressing | | |
|---|---|---|---|---|---|
| Container used | Reference Example 1 | Example 1 | Reference Example 1 | Example 1 | Example 15 |
| Roll-off property (Evaluation, seconds) | E, >300 seconds | A, 7 seconds | E, >300 seconds | A, 5 seconds | B, 15 seconds |
| Residual liquid amount (after 300 seconds) | 18.76 g | 3.51 g | 3.52 g | 0.84 g | 1.55 g |

**Table 7**

| | Emulsified Dressing | |
|---|---|---|
| Container used | Reference Example 1 | Example 1 |
| Residual liquid amount after 60 seconds | 26.25 g | 22.70 g |
| Residual liquid amount after washing and drying | 4.74 g | 1.60 g |

From the results of Table 6 and Table 7, it can be confirmed that Example 1 and Example 15 have less residual liquid than Reference Example 1. This is considered to be due to good liquid repellency.

### (Evaluation using Mayonnaise-type Dressing)

### <Evaluation Sample>

The uncoated commercially available polyethylene terephthalate container for edible oils and/or fats used in the section "Preparation of Silicon Oxide Vapor-Deposited Film and Molded Article" above (PET container: usable capacity 600 g, inner diameter of the upper opening 27.6 mm, height 218.7 mm) was designated as Reference Example 1.

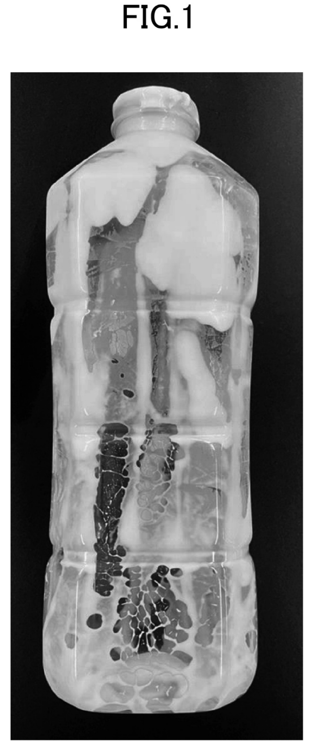

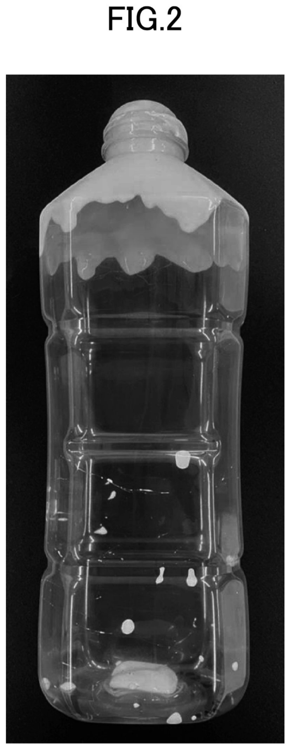

Using the coated polyethylene terephthalate container for edible oils and/or fats of Example 1 above and the uncoated commercially available polyethylene terephthalate container for edible oils and/or fats of Reference Example 1, 600 g of a mayonnaise-type dressing (commercial product name "Nisshin Mayo-Dre," manufactured by The Nisshin OilliO Group, Ltd.: 58% by mass of oils and/or fats) was filled, and then the container was turned upside down and the side of the bottle was pressed to discharge the inner liquid (filled mayonnaise-type dressing) from the opening. Furthermore, it was allowed to stand for 5 days with the opening facing downward in a room set to 5°C, and a photograph of the state after 5 days was taken. The photographs are shown in Fig. 1 for Reference Example 1 and Fig. 2 for Example 1.

From Figs. 1 and 2, it was confirmed that Example 1 has less adhesion of the mayonnaise-type dressing than Reference Example 1.

### (Evaluation using Liquid Paraffin)

### <Evaluation Sample>

Using the coated polyethylene terephthalate container for edible oils and/or fats of Example 1 above and the uncoated commercially available polyethylene terephthalate container for edible oils and/or fats of Reference Example 1, the roll-off property of liquid paraffin (manufactured by Kanto Chemical Co., Inc., CAS number: 8012-95-1) was analyzed and evaluated as follows.

### [Analysis Method]

### (Roll-off property of Liquid Paraffin)

A2 cm square PET plate was cut out from the flat part of the container for storing an oil and/or fat-containing composition of the Example and Reference Example (container sample) to obtain an evaluation sample, and one drop (27.3 mg) of the liquid paraffin was dropped onto the surface of the evaluation sample with a dropper. Immediately after dropping, the sample was placed on a stage ("Stage (angle tilt)" manufactured by AS ONE Corporation) set at an inclination of 50° with respect to the vertical, and the time for the rear end of the liquid droplet (the uppermost point of contact between the sample surface and the oil and/or fat droplet) to move 6 mm on the evaluation sample surface was measured. Note that the temperature during the measurement was room temperature (23°C).

Based on the movement time, an evaluation was performed based on the following criteria of A to E, and if it was A to D, it was considered to have a roll-off property and/or oil repellency for the oil and/or fat-containing composition. Also, here, it can be determined that the shorter the movement time, the higher and better the roll-off property and/or liquid repellency of the dressing.
Evaluation A: no more than 10 seconds
Evaluation B: more than 10 seconds to 20 seconds
Evaluation C: more than 20 seconds to 60 seconds
Evaluation D: more than 60 seconds to 300 seconds
Evaluation E: more than 300 seconds

**Table 8**

| Container used | Reference Example 1 | Example 1 |
|---|---|---|
| Roll-off property (seconds) | >300 seconds | 9 seconds |
| Evaluation | E | A |

From Table 8, it was confirmed that Example 1 is superior in the roll-off property of liquid paraffin than Reference Example 1. It can be said that Example 1 has the effect of increasing roll-off property not only for vegetable oils and/or fats but also for mineral oils and/or fats.

## Claims

1. A silicon oxide vapor-deposited film, wherein
a surface of the silicon oxide vapor-deposited film has a ratio of ion intensity AO to ion intensity B (ion intensity AO/ion intensity B) of 3 or more in an ion intensity spectrum obtained by time-of-flight secondary ion mass spectrometry,
the ion intensity B is the sum of intensities of the positive ion at m/z 78.99 and the positive ion at m/z 138.95, and
the ion intensity AO is the sum of intensities of the negative ion at m/z 31.02, the negative ion at m/z 59.00, the negative ion at m/z 74.99, the positive ion at m/z 102.97, and the negative ion at m/z 134.96.

2. The silicon oxide vapor-deposited film according to claim 1, wherein
a ratio of ion intensity AO to ion intensity A (ion intensity AO/ion intensity A) is 0.1 or more, and
the ion intensity A is the sum of intensities of the positive ion at m/z 43.00, the positive ion at m/z 59.03, and the positive ion at m/z 73.05.

3. The silicon oxide vapor-deposited film according to claim 1 or 2, wherein the silicon oxide vapor-deposited film satisfies at least one of the following conditions:
a ratio of the sum of ion intensities A and AO to ion intensity S ((ion intensity A+ion intensity AO)/ion intensity S) is 10 or more; or
a ratio of ion intensity AO to ion intensity S (ion intensity AO/ion intensity S) is 0.7 or more, wherein
the ion intensity S is an intensity of the positive ion at m/z 43.97, and
the ion intensity A is the sum of intensities of the positive ion at m/z 43.00, the positive ion at m/z 59.03, and the positive ion at m/z 73.05.

4. The silicon oxide vapor-deposited film according to any one of claims 1 to 3, wherein the silicon oxide vapor-deposited film is a film derived from hexamethyldisiloxane.

5. A molded article, having a surface coated with the silicon oxide vapor-deposited film according to any one of claims 1 to 4.

6. The molded article according to claim 5, wherein the molded article is a container, a pipe, or a cooking utensil molded from a material selected from the group consisting of resin, glass, metal, ceramics, and paper.

7. A method for producing a molded article coated with a silicon oxide vapor-deposited film, comprising a step of coating a surface of a molded article with the silicon oxide vapor-deposited film according to claim 5 or 6 by a plasma CVD method.
